# EUROPÄISCHE PATENTSCHRIFT

(11) **EP 1 997 361 B1**
(45) Veröffentlichungstag und Bekanntmachung des Hinweises auf die Patenterteilung: **12.09.2018**
(21) Anmeldenummer: 06818878.8
(22) Anmeldetag: 28.11.2006
(51) Int. Cl.: H05K 7/20

(54) **GEHÄUSE MIT WÄRMEBRÜCKE**
HOUSING HAVING HEAT BRIDGE
BOITIER AVEC PONT THERMIQUE

(30) Priorität: 20.03.2006 DE 102006013017
(43) Veröffentlichungstag der Anmeldung: 03.12.2008
(73) Patentinhaber: R. Stahl Schaltgeräte GmbH, 74638 Waldenburg (DE)
(72) Erfinder: POIDL, Jürgen, 74553 Kocherstetten (DE)
(74) Vertreter: Rüger, Barthelt & Abel
(86) Internationale Anmeldenummer: PCT/EP2006/011396
(87) Internationale Veröffentlichungsnummer: WO 2007/107178

(56) Entgegenhaltungen:
- WO-A-99/27761
- US-A- 5 812 375
- US-A1- 2003 213 586
- US-B1- 6 396 691

## Beschreibung

Gehäuse, die die zündschutzdruckfeste Kapselung, Ex-d erfüllen, werden dazu verwendet, elektrische und elektronische Bauteile aufzunehmen, die für sich genommen keinerlei Explosionsvorschriften erfüllen. Solche Gehäuse sind, abgesehen von sehr engen Zünddurchschlagssicheren Spalten, im Bereich von mechanischen Durchführungen hermetisch dicht. Die Spaltweite solcher Ex-d-Spalte ist so bemessen, dass im Falle einer Zündung eines zündfähigen Gasgemisches im Inneren des Gehäuses keine Partikel nach Außen gelangen können, die ein zündfähiges Gemisch in der Außenumgebung des Gehäuses entzünden können. Die Spaltweite bewegt sich im Bereich von Zehntel Millimetern.

Entsprechend schwierig ist es, Einzelhalbleiter mit großer Verlustleistung innerhalb eines solchen Gehäuses zu kühlen.

Die US 5,812,375 beschreibt ein Gehäuse mit einer Wärmebrücke. Die Wärmebrücke ist durch einen in das Innere des Gehäuses ragenden Vorsprung gebildet. Auf diesen Vorsprung sitzt eine Leiterplatte mit elektrischen bzw. elektronischen Komponenten. Dabei kann der Vorsprung beispielsweise in eine entsprechende Ausnehmung an der Unterseite der Leiterplatte eingreifen. Der Vorsprung ist integraler Bestandteil der Gehäusewand. Es ist daher erforderlich, abhängig von der Anordnung, der Anzahl und der Art der elektrischen bzw. elektronischen Komponenten im Gehäuse eine jeweils angepasste Gussform zur Herstellung der Gehäusewand vorzuhalten oder auf andere Art und Weise unterschiedliche Gehäusewände herzustellen.

Aus US 2003/0213586 A1 ist eine Gehäuse mit einer integral an der Außenseite angeformten Erhebung bekannt, die eine Montagefläche für einen Kühlkörper aufweist.

Ausgehend hiervon ist es Aufgabe der Erfindung, ein Gehäuse zu schaffen, mit dem eine Kühlung von innerhalb des Gehäuses angeordneten Wärmerzeugern auf einfache Weise möglich ist.

Diese Aufgabe wird erfindungsgemäß mit dem Gehäuse mit den Merkmalen des Anspruches 1 gelöst.

Das erfindungsgemäße Gehäuse weist einen im Wesentlichen hermetisch geschlossenen Innenraum auf, der von Gehäusewänden umgeben wird. Wenigstens eine der Gehäusewände enthält eine Wärmbrücke, über die gezielt aus dem Innenraum Wärme nach Außen geschafft werden kann. Diese Wärmebrücke umfasst eine aus der Gehäusewand nach innen vorstehende Erhöhung, an der sich eine Montagefläche befindet, die das zu kühlende Bauteil aufweist. Fluchtend mit der nach innen vorstehenden Erhöhung ist auf der Außenseite eine weitere Erhöhung vorgesehen, die eine Montagefläche für einen Kühlkörper trägt. Aufgrund der Verwendung von einzelnen Erhöhungen, sowohl auf der Innenseite als auch auf der Außenseite der Gehäusewand, vereinfacht sich erheblich die Bearbeitung zum Erzeugen der Montageflächen.

In der Regel müssen die Montageflächen im Sinne eines geringen Wärmewiderstands für zu kühlende Bauelement beziehungsweise zum Kühlkörper hin besonders plan bearbeitet werden. Wenn es sich bei dem Gehäuse um ein Gussgehäuse handelt, sind naturgemäß die Oberflächen verhältnismäßig rau. Eine Bearbeitung im Sinne einer Erzeugung einer planen Montagefläche bedeutet an dem betreffenden Ort der Wand eine Materialschwächung, die aus Gründen des Explosionsschutzes in der Regel nicht hingenommen werden kann, es sei denn im übrigen Bereich wird die Wand so überdimensioniert, dass sie auch nach der Bearbeitung im Bereich der Montageflächen noch hinreichend dick ist.

Die Erfindung geht an dieser Stelle einen umgekehrten Weg, der darin besteht, dass die Wand im Bereich dort wo die Wärmebrücke erzeugt werden soll, dicker ist als im sonstigen Bereich. Dadurch ist es ohne Weiteres möglich, im Bereich der Wärmebrücke Material abzutragen, ohne hierdurch die Festigkeit oder die Druckfestigkeit des Gehäuses zu beeinträchtigen. Außerdem ist es auf diese Weise möglich, ohne Weiteres an unterschiedlichen Wänden und damit räumlich voneinander getrennt, Wärmebrücken vorzusehen. Hierdurch können die auf der Außenseite des Gehäuses vorhandenen Kühlkörper oder Kühlelemente ebenfalls räumlich voneinander getrennt werden um eine wechselseitige Beeinträchtigung der Kühlwirkung weitgehend auszuschließen.

Schließlich hat die Verwendung von Wärmebrücken unter Verwendung von örtlich beschränkten Erhöhungen auf der Innen- und der Außenwand den Vorteil, einen geringeren Wärmeverzug in der Gehäusewand zu induzieren. Auch letzteres ist von Bedeutung, insbesondere bei großen Gehäusen, weil bei starkem Verzug die Gefahr besteht, dass der Deckel des Gehäuses unter Umständen nicht mehr die Explosionsvorschriften erfüllt. Der Spalt zwischen Deckel und Gehäusezarge könnte durch den Verzug größer als zulässig werden. Die massive bzw. räumlich konzentrierte Wärmebrücke, die konzentriert an ihrem Ort die Wärme aus dem Gehäuse heraus schafft, hält die Wärme von der übrigen Wand weitgehend weg.

Darüber hinaus können durch die Erhöhungen auch Beeinträchtigungen eliminiert werden, die sonst von irgendwelchen Verstärkungsrippen auf der Wand ausgehen könnten.

Vorteilhafterweise ist das Gehäuse mit wenigstens einer im Wesentlichen ebenen Gehäusewand versehen.

Die erfindungsgemäße Lösung lässt sich sowohl bei runden als auch quadratischen oder quaderförmigen Gehäusen verwenden.

Zweckmäßigerweise besteht die Gehäusewand, in der die Wärmebrücke ausgebildet ist, aus einem gut wärmeleitenden Material. Die Erhöhung auf der Innen- und der Außenseite kann dann unmittelbar aus dem Wandmaterial einstückig hergestellt sein.

Darüber ist die Wärmebrücke als Bolzen in einer entsprechenden Öffnung in der Gehäusewand vorzusehen, , wobei der Bolzen entsprechend abgedichtet durch die Gehäusewand hindurch führt. Als Öffnungen kommen hierfür Gewindeöffnungen in Frage, in die der die Wärmebrücke bildende Bolzen als Gewindebolzen eingeschraubt und mit dem Bohrungsgewinde verklebt ist.

Anstelle der Verklebung ist es auch möglich, den Bolzen unter Ausbildung eines Ex-Spaltes einzusetzen. Hierbei kann das Gewinde bei entsprechender Gestaltung als Ex-Spalt dienen.

Günstige Verhältnisse ergeben sich, wenn die Erhöhungen kegelstumpf- oder pyramidenstumpfähnlich sind. Die Erhöhungen sind dabei auf der Innen- und der Außenseite mit ihrer jeweils größeren Querschnittsfläche einander zugekehrt.

Eine günstige Befestigungsmöglichkeit ergibt sich, wenn die Montagefläche eine Planfläche ist.

Wenn mehr Wärme übertragen werden muss, können ohne Weiteres mehrere derartige Wärmebrücken nebeneinander verwendet werden, von denen jede entweder eine Gruppe von Bauelementen oder jeweils ein einzelnes Bauelement trägt. Auf der Außenseite können sämtliche Wärmebrücken an einen gemeinsamen Kühlkörper angeschlossen werden.

Zum Befestigen der Kühlkörper beziehungsweise der Bauelemente können die Wärmebrücken in den Montageflächen beziehungsweise Planflächen Gewindebohrungen enthalten. Diese Bohrungen sind zweckmäßigerweise als Sackbohrungen ausgeführt, um unerwünschte Durchlässe im Bereich der Bohrungen zu vermeiden.

In der nachfolgenden Figurenbeschreibung sind prinzipielle Ausführungsbeispiele veranschaulicht. Beim Durchlesen der Figurenbeschreibung wird klar, dass die Einzelmerkmale der Ausführungsbeispiele beliebig miteinander kombiniert werden können. Sämtliche Unterkombinationen an einzelnen Ausführungsbeispielen zu erläutern, würde den Umfang unnötig aufblähen.

Im Übrigen sind Weiterbildungen der Erfindung Gegenstand von Unteransprüchen.

In der Zeichnung zeigen:
- Fig. 1: ein druckfest gekapseltes Gehäuse in einer perspektivischen aufgebrochenen Darstellung unter Veranschaulichung einer nicht erfindungsgemäßen Wärmebrücke und
- Fig. 2: ein erfindungsgemässes Ausführungsbeispiel in einer Darstellung ähnlich wie Fig. 1, mit einer anderen Ausführungsform der Wärmebrücke

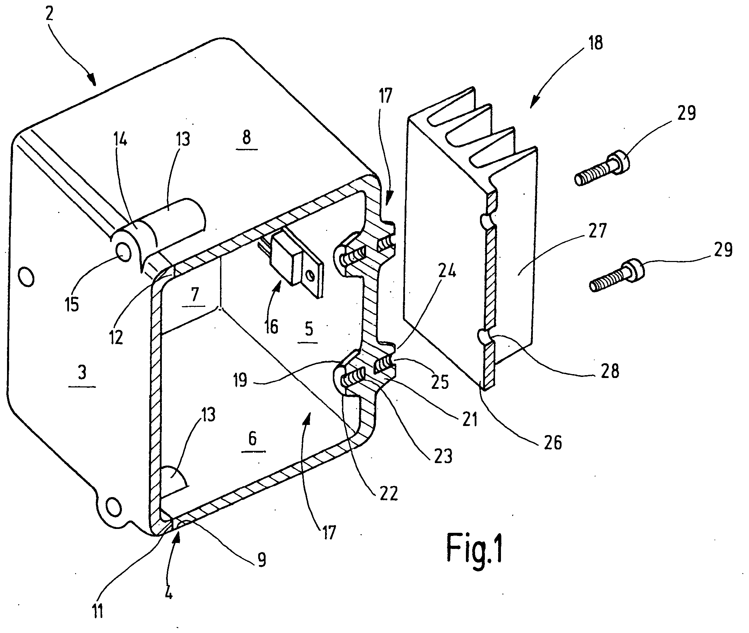

Fig. 1 zeigt in einer schematisierten Form ein aufgeschnittenes Gehäuse 1, in der Zündschutzart "druckfeste Kapselung", "Ex-d". Das Gehäuse 1 weist einen Gehäusegrundkörper 2 auf, der durch einen Deckel 3 verschlossen ist. Der Deckel 3 bildet mit der Auflagefläche am Gehäusegrundkörper 2 einen Ex-d-Spalt 4.

Der Gehäusegrundkörper 1 wird von einer Gehäuserückwand und einer die Gehäuserückwand 5 umgebenden Zarge aus einer Bodenwand 6, einer sichtbaren Gehäusewand 7, einer Gehäusedach 8 und einer weggeschnittenen Gehäusewand, die zu der Gehäusewand 7 parallel ist, gebildet. Die einzelnen Wände verlaufen paarweise zueinander parallel, so dass sich insgesamt eine quaderförmige Gestalt ergibt.

Der Gehäuseboden 6, die beiden Gehäuseseitenwände 7 sowie das Gehäusedach 8 bilden eine in sich geschlossene ringförmige Deckelauflagefläche 9. Die Deckelauflagefläche 9 bildet eine Seite des Ex-Spalts 4.

Die Gehäuserückwand 5, die Bodenwand 6 und die Gehäuseseitenwände 7 sowie das Gehäusedach 8 sind im Wesentlichen ebene Gebilde mit etwa zueinander parallelen dem Gehäuseinneren zugekehrten Planseiten und im Wesentlichen ebenen nach außen zeigenden Planflächen.

Der Gehäusedeckel 3 ist ebenfalls geringfügig schalenförmig ausgebildet und trägt an seinem schalenförmigen Deckelrand 11 eine Auflagefläche 11 für den Gehäusegrundkörper 2. Die Auflagefläche 12, die zu der Deckelauflagefläche 9 komplementär ist und bildet die andere Seite des Ex-Spalts 4.

Im Bereich der Deckelauflagefläche 9 sind an dem Gehäusegrundkörper 2 eine Reihe von wulstförmigen Angüssen 13 vorhanden, die rechtwinklig zu dem Ex-Spalt 4 verlaufen und die mit komplementären Angüssen 14 oder Verdickungen an dem Deckel 3 korrespondieren. In diesen Angüssen 13 befinden sich Gewindebohrungen, in die Schrauben einschraubbar sind, die durch Stufenbohrungen 15 in den Angüssen 14 hindurchführen, um den Deckel 3 mit dem Gehäusegrundkörper 2 verschrauben zu können.

Das gezeigte Gehäuse 1 dient der Aufnahme von elektronischen Bauelementen, von denen eines in Gestalt eines Leistungstransistors 16 im SOT 220 Gehäuse gezeigt ist.

Um die Wärme von dem elektronischen Bauelement 16 oder weiteren Bauelementen abführen zu können, führen durch die Gehäuserückwand 5 mehrere voneinander räumlich getrennte Wärmebrücken 17 hindurch. Über die Wärmebrücken werden die wärmeerzeugenden Bauelemente 16 mit einem außerhalb montierten Rippenkühlkörper 18 wärmetechnisch gekoppelt.

Jede Wärmebrücke 17 setzt sich aus einem in das Gehäuseinnere vorragenden kegelstumpfförmigen Fortsatz 19 und einem damit korrespondierenden aus der Außenseite der Gehäuserückwand vorstehenden kegelstumpfförmigen Fortsatz 21 zusammen. Die beiden kegelstumpfförmigen Fortsätze 19 und 21 jeder Wärmebrücke 17 fluchten miteinander, in der Weise, dass sie auf einer gemeinsamen Achse liegen, die senkrecht auf der Gehäuserückwand 5 steht.

Der innere kegelstumpfförmige Fortsatz endet an einer Planfläche 22, die als Montagefläche für den Leistungshalbleiter 16 dient. Die Montagefläche 22 wird von einer Gewindesackbohrung 23 durchsetzt.

Bei dem gezeigten Ausführungsbeispiel sind alle im Gehäuseinnenraum liegenden Montage- oder Plateauflächen 22 in einer gemeinsamen Ebene, womit es auch möglich ist, größere wärmeabgebende Bauelemente auf mehreren Wärmebrücken 17 zu befestigen.

Der kegelstupfförmige Fortsatz 21 auf der Außenseite ist ähnlich gebildet, dass heißt er weist eine nach außen zeigenden Montage- oder Planfläche 24 auf, durch die koaxial eine Gewindesackbohrung 25 hindurchführt. Auch auf der Außenseite sind die Wärmebrücken 17 in gleicher weise gestaltet, so dass die Plateauflächen oder Montageflächen 24 auf der Außenseite in der selben Ebene liegen. Auf diese Weise wird es möglich, den Kühlkörper 18 für mehrere Wärmebrücken 17 verwenden zu können. Bei jeder Wärmebrücke 17 sind die zugehörigen kegelstumpfförmigen Fortsätze mit ihren Basisflächen einander zugekehrt.

Der Kühlkörper 18 weist wie üblich eine plane Montagefläche 26 auf, von der zur gegenüberliegenden Seite Kühlrippen 27 wegführen. Zwischen entsprechenden Kühlrippen befinden sich Durchgangsbohrungen 28 für Befestigungsschrauben 29, mit denen der Kühlkörper 18 an in diesem Beispiel den beiden sichtbaren Wärmebrücken 17 zu befestigen ist.

Die gezeigte Ausführungsform der in einer Gehäusewand einstückig integrierten Wärmebrücken 17 eignet sich insbesondere für Gehäuse, die aus einer gut wärmeleitenden Metalllegierung, beispielsweise einer Aluminiumlegierung, bestehen.

Da die Wärmebrücken 17 sich auf der Innenseite erheben, sind die Plan- oder Montageflächen 22 in besonders einfacher Weise herzustellen, ohne dass bei dem Herstellungsverfahren die Gehäusewand geschwächt wird. Dies ist insbesondere von Vorteil, wenn das Gehäuse, wie bei solchen Gehäusen üblich, als Gussgehäuse hergestellt wird. Zufolge der Gusstechnik wären die Montageflächen rau und hätten auch erhebliche Tollranzen. Bei der gezeigten Ausführungsform lassen sich die angegossenen kegelstumpfförmigen Fortsätze 19 auf ihrer Montageflächenseite leicht spangebend bearbeiten.

Die Wärmebrücken 17 können günstig positioniert werden. Insbesondere ist es auch leicht möglich, alle Wärmebrücken 17 so zu gestalten, dass die Montageflächen wie erläutert in einer gemeinsamen Ebene liegen. Dadurch lassen sich auch großvolumige wärmeerzeugende Elemente auf mehreren Wärmebrücken 17 montieren. Ebenso ist es möglich, eine wärmeleitende Platte auf mehreren Wärmebrücken 17 zu positionieren, wobei die wärmeleitende Platte dann mehrere einzelne Leistungshalbleiter 16 oder andere wärmeerzeugende Bauelemente aufnimmt. Die Wärme wird konzentriert über die Wärmebrücken 17 nach Außen zu dem Kühlkörper 18 geschafft.

Für die auf der Außenseite befindlichen kegelstumpfförmigen Fortsätze der Wärmebrücken 17 gilt herstellungstechnisch dasselbe, wie es oben für die nach innen zeigenden kegelstumpfförmigen Fortsätze erläutert ist. Die Bearbeitung des Gehäuses wird wesentlich vereinfacht. Es muss wenig Material abgetragen werden um die ebene Montagefläche für den großen Kühlkörper 18 zu schaffen.

Da die Befestigungsbohrungen jeweils als Sackbohrungen ausgeführt sind, bleibt die Dichtigkeit des Gehäuses erhalten. Die kegelstumpfförmigen Erhöhungen begünstigen auch die Unterbringung der Sackbohrungen mit genügender Einschraubtiefe.

Die Erfindung ist in Verbindung mit einem Gehäuse in der "Zündschutzart druckfeste Kapselung" beschrieben. Es leuchtet jedoch ohne Weiteres ein, dass die erfindungsgemäße Lösung auch bei Gehäusen in der "Zündschutzart Sandkapselung" vorteilhaft angewendet werden kann. Auch hier besteht die Schwierigkeit, die Wärme von den wärmeerzeugenden elektronischen oder elektrischen Bauelementen nach außen zu schaffen. Sand ist ein verhältnismäßig schlechter Wärmeleiter und isoliert die Bauelemente wärmetechnisch recht gut. Entsprechend schwierig ist es, die Wärme von den Bauelementen nach außen zu schaffen. Mit der erfindungsgemäßen Lösung ist dies ohne Weiteres möglich.

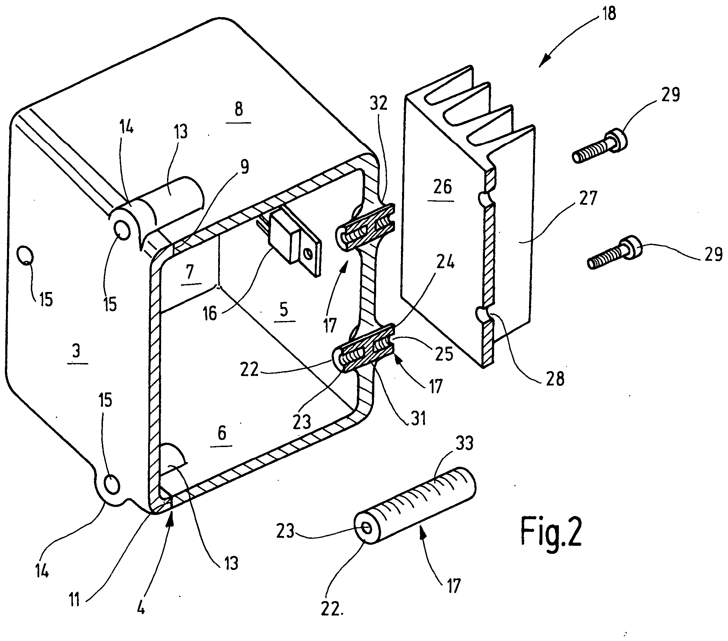

Fig. 2 zeig eine erfindungsgemässe Ausführungsform für die Wärmebrücken 17. Hier bestehen die Wärmebrücken aus einzelnen zylinderförmigen Bolzen 17, die in entsprechenden Durchgangsbohrungen 31 in der Gehäuserückwand eingesetzt sind.

Fig. 2 zeigt ein Gehäuse 1 in einer ähnlichen Darstellung wie Fig. 1. Zum Unterschied von Fig. 1 sei hier angenommen, dass die Gehäusewand schlecht wärmeleitend ist, beispielsweise weil die betreffende Gehäuserückwand 5 aus einem faserverstärkten Kunststoffmaterial besteht. Um dennoch durch einen solchen verhältnismäßig guten Wärmeisolator die Wärme gezielt nach außen bringen zu können, sind wie erwähnt in der Gehäuserückwand 5 Durchgangslöcher 31 vorgesehen. Bei entsprechender Materialdicke der Gehäuserückwand genügt es, diese Öffnungen vorzusehen. Wenn die Materialstärke zu gering ist, ist es vorteilhaft, wenn die Gehäuserückwand 5, wie aus Fig. 2 zu sehen, in der Umgebung der Bohrungen 31 mit kegelstumpfförmigen Verdickungen 32 versehen ist. Die Wärmebrücke 17 in Gestalt beispielsweise eines Kupferbolzens wird in diese Öffnung 31 abgedichtet eingesetzt. Hierzu ist es möglich, die Kupferbolzen 17, wie in der vergrößerten Detailzeichnung zu erkennen ist, mit einem Außengewinde 33 zu versehen, das in ein entsprechendes Innengewinde in der Bohrung 31 eingeklebt wird.

Der Kupferbolzen enthält wiederum die Sackbohrungen 23 und 25, an denen der wärmeerzeugende Halbleiter 16 fest zu schrauben ist.

Nach dem Einsetzen der Kupferbolzen 17 werden diese wie zuvor beschrieben stirnseitg bearbeitet, wenn eine gleiche Höhe erwünscht ist.

Als weitere Variante ist noch denkbar, die als Bolzen ausgeführte Wärmebrücke 17 in eine glatte Öffnung 31 einzusetzen und von beiden Seiten her mit entsprechenden Muttern gegen das Gehäuse fest zu schrauben, was allerdings den Nachteil hat, dass hier gegebenenfalls eine Bearbeitung der Oberfläche neben der Durchgangsöffnung erforderlich ist. Im Falle der eingeschraubten und festgeklebten Wärmebrücken 17 erübrigt sich eine derartige Vorbereitung. Es genügt, wenn nach dem Einkleben der Wärmebrücken 17 diese an den Stirnseiten bearbeitet werden, um die Montageflächen zu erzeugen.

Ein hermetisch dichtes Gehäuse oder ein Gehäuse, das in einer der hierfür vorgesehenen Zündschutzarten ausgeführt ist, ist an diskreten Stellen mit Wärmebrücken versehen. Die Wärmebrücken bilden in dem Innenraum des Gehäuses Montageflächen und außerdem Montageflächen auf der Außenseite. Über die Wärmebrücken wird an den entsprechenden Stellen die Wärme vom Inneren des Gehäuses nach Außen abgeleitet.

## Patentansprüche

1. Gehäuse in der Zündschutzart druckfeste Kapselung oder in der Zündschutzart Sandkapselung, das die Anforderungen im Ex-d Bereich erfüllt, mit einen geschlossenen Innenraum umgebenden Gehäusewänden (3,5,6,7,8),
mit wenigstens einer Wärmebrücke (17), zu der
- eine aus der Gehäusewand (5) nach innen über die Gehäusewand (5) vorstehende Erhöhung (19), die eine Montagefläche (22) für ein zu kühlendes Bauteil (16) aufweist, und
- eine nach außen über die Gehäusewand (5) erhebende Erhöhung (21)
gehören, die mit der nach innen vorstehenden Erhöhung (19) auf einer gemeinsamen Achse liegt, die auf der Gehäusewand (5) senkrecht steht, und die mit einer Montagefläche (25) für einen Kühlkörper (18) versehen ist,
wobei die Wärmebrücke (17) von einem durch die Gehäusewand (5) führenden Bolzen gebildet ist, der mit einem Ende die innenliegende Erhöhung und mit dem anderen Ende die außenliegende Erhöhung bildet.

2. Gehäuse nach Anspruch 1, **dadurch gekennzeichnet, dass** das Gehäuse (1) wenigstens eine im wesentlichen ebene Gehäusewand (3, 5, 6, 7, 8) aufweist.

3. Gehäuse nach Anspruch 1, **dadurch gekennzeichnet, dass** das Gehäuse (1) quaderförmig ist.

4. Gehäuse nach Anspruch 1, **dadurch gekennzeichnet, dass** die Gehäusewand (5) aus einem gut wärmeleitenden Material besteht.

5. Gehäuse nach Anspruch 1, **dadurch gekennzeichnet, dass** der Bolzen (17) unter Ausbildung eines Ex-Spaltes in eine Öffnung (31) in der Gehäusewand (5) eingesetzt ist.

6. Gehäuse nach Anspruch 5, **dadurch gekennzeichnet, dass** der Bolzen (17) in eine Gewindebohrung (31) eingeschraubt ist.

7. Gehäuse nach Anspruch 1, **dadurch gekennzeichnet, dass** die Erhöhungen (19,21) mit der Gehäusewand (5) einstückig sind.

8. Gehäuse nach Anspruch 1, **dadurch gekennzeichnet, dass** die innenliegende und die außen liegende Erhöhung (19,21) jeweils eine kegelstumpf- oder pyramidenstumpfförmige Gestalt aufweist.

9. Gehäuse nach Anspruch 1, **dadurch gekennzeichnet, dass** die Erhöhungen (19,21) mit ihrer größeren Querschnittsfläche einander zugekehrt sind.

10. Gehäuse nach Anspruch 1, **dadurch gekennzeichnet, dass** die beiden Erhöhungen (19,21) deckungsgleich auf der Gehäusewand (5) angeordnet sind.

11. Gehäuse nach Anspruch 1, **dadurch gekennzeichnet, dass** wenigstens eine der Montageflächen (22,25) eine Planfläche ist.

12. Gehäuse nach Anspruch 11, **dadurch gekennzeichnet, dass** die Planfläche (22,25) parallel zu einer durch die Gehäusewand (5) definierten Ebene liegt.

13. Gehäuse nach Anspruch 1, **dadurch gekennzeichnet, dass** in einer Gehäusewand (5) mehrere Wärmebrücken (17) vorgesehen sind.

14. Gehäuse nach Anspruch 1, **dadurch gekennzeichnet, dass** die Wärmebrücken (17) ineinander übergehen oder voneinander getrennt sind.

15. Gehäuse nach Anspruch 1, **dadurch gekennzeichnet, dass** die Wärmebrücken (17) auf der Außenseite der Gehäusewand (5) Montageflächen (25) bilden, die in einer gemeinsamen Ebene liegen.

16. Gehäuse nach Anspruch 1, **dadurch gekennzeichnet, dass** die Wärmebrücken (17) auf der Innenseite der Gehäusewand (5) Montageflächen (19) bilden, die in einer gemeinsamen Ebene liegen.

17. Gehäuse nach Anspruch 1, **dadurch gekennzeichnet, dass** die Montageflächen (19,21) Gewindebohrungen (22,25) enthalten.

18. Gehäuse nach Anspruch 17, **dadurch gekennzeichnet, dass** die Gewindebohrungen (22,25) Sackbohrungen sind.

## Claims

1. Housing with explosion protection of the pressure-tight encapsulation or sand encapsulation type which meets the requirements in the Ex-d sector,
with housing walls (3, 5, 6, 7, 8) surrounding a closed interior,
with at least one heat bridge (17) comprising:
- a protuberance (19) which protrudes from the housing wall (5) inwardly beyond the housing wall (5) and has a mounting face (22) for a component (16) to be cooled,
- a protuberance (21) which protrudes outwardly beyond the housing wall (5), and which lies on a common axis, standing perpendicularly to the housing wall (5), with the inwardly protruding protuberance (19), and which has a mounting face (25) for a cooling body (18),
wherein the heat bridge (17) is formed by a bolt which leads through the housing wall (5) and with one end forms the inner protuberance and with the other end forms the outer protuberance.

2. Housing according to claim 1, **characterised in that** the housing (1) has at least one substantially flat housing wall (3, 5, 6, 7, 8).

3. Housing according to claim 1, **characterised in that** the housing (1) is cuboid.

4. Housing according to claim 1, **characterised in that** the housing wall (5) consists of a material with good heat conduction.

5. Housing according to claim 1, **characterised in that** the bolt (17) is inserted in an opening (31) of the housing wall (5) forming an Ex gap.

6. Housing according to claim 5, **characterised in that** the bolt (17) is screwed into a threaded bore (31).

7. Housing according to claim 1, **characterised in that** the protuberances (19, 21) are integral to the housing wall (5).

8. Housing according to claim 1, **characterised in that** the inner and the outer protuberance (19, 21) are each formed as a truncated cone or truncated pyramid.

9. Housing according to claim 1, **characterised in that** the protuberances (19, 21) face each other with their larger cross-sectional faces.

10. Housing according to claim 1, **characterised in that** the two protuberances (19, 21) are arranged congruently on the housing wall (5).

11. Housing according to claim 1, **characterised in that** at least one of the mounting faces (22, 25) is a planar face.

12. Housing according to claim 11, **characterised in that** the planar face (22, 25) lies parallel to a plane defined by the housing wall (5).

13. Housing according to claim 1, **characterised in that** several heat bridges (17) are provided in a housing wall (5).

14. Housing according to claim 1, **characterised in that** the heat bridges (17) transform into each other or are separate from each other.

15. Housing according to claim 1, **characterised in that** the heat bridges (17) form mounting faces (25) which lie in a common plane on the outside of the housing wall (5).

16. Housing according to claim 1, **characterised in that** the heat bridges (17) form mounting faces (19) which lie in a common plane on the inside of the housing wall (5).

17. Housing according to claim 1, **characterised in that** the mounting faces (19, 21) comprise threaded bores (22, 25).

18. Housing according to claim 17, **characterised in that** the threaded bores (22, 25) are blind bores.

## Revendications

1. Boîtier du type de protection par enveloppe antidéflagrante ou du type de protection par remplissage pulvérulent, qui répond aux exigences dans le domaine Ex-d,
comprenant des parois de boîtier (3, 5, 6, 7, 8) entourant un espace interne fermé,
comprenant au moins un pont thermique (17) qui comporte
- une saillie (19) qui avance vers l'intérieur à partir de la paroi de boîtier (5), au-delà de la paroi de boîtier (5), et qui présente une surface de montage (22) pour un composant (16) à refroidir, et
- une saillie (21) s'élevant vers l'extérieur, au-delà de la paroi de boîtier (5),
qui se situe sur un axe commun avec la saillie (19) s'étendant vers l'intérieur, lequel axe est perpendiculaire à la paroi de boîtier (5), et qui est dotée d'une surface de montage (25) pour un corps de refroidissement (18),
le pont thermique (17) étant constitué d'une tige qui traverse la paroi de boîtier (5) et qui forme avec une extrémité la saillie intérieure et avec l'autre extrémité la saillie extérieure.

2. Boîtier selon la revendication 1, **caractérisé en ce que** le boîtier (1) présente au moins une paroi de boîtier (3, 5, 6, 7, 8) sensiblement plane.

3. Boîtier selon la revendication 1, **caractérisé en ce que** le boîtier (1) a une forme parallélépipédique.

4. Boîtier selon la revendication 1, **caractérisé en ce que** la paroi de boîtier (5) est constituée d'un matériau bon conducteur thermique.

5. Boîtier selon la revendication 1, **caractérisé en ce que** la tige (17) est insérée dans une ouverture (31) de la paroi de boîtier (5) en formant un interstice antidéflagrant.

6. Boîtier selon la revendication 5, **caractérisé en ce que** la tige (17) est vissée dans un trou taraudé (31).

7. Boîtier selon la revendication 1, **caractérisé en ce que** les saillies (19, 21) sont réalisées d'une seule pièce avec la paroi de boîtier (5).

8. Boîtier selon la revendication 1, **caractérisé en ce que** les saillies intérieure et extérieure (19, 21) présentent respectivement une forme de cône tronqué ou de pyramide tronquée.

9. Boîtier selon la revendication 1, **caractérisé en ce que** les saillies (19, 21) sont tournées l'une vers l'autre avec leur plus grande surface de section transversale.

10. Boîtier selon la revendication 1, **caractérisé en ce que** les deux saillies (19, 21) sont disposées sur la paroi de boîtier (5) de manière à coïncider l'une avec l'autre.

11. Boîtier selon la revendication 1, **caractérisé en ce qu'**au moins une des surfaces de montage (22, 25) est une surface plane.

12. Boîtier selon la revendication 11, **caractérisé en ce que** la surface plane (22, 25) est parallèle à un plan défini par la paroi de boîtier (5).

13. Boîtier selon la revendication 1, **caractérisé en ce que** plusieurs ponts thermiques (17) sont prévus dans une paroi de boîtier (5).

14. Boîtier selon la revendication 1, **caractérisé en ce que** les ponts thermiques (17) se raccordent les uns aux autres ou sont séparés les uns des autres.

15. Boîtier selon la revendication 1, **caractérisé en ce que** les ponts thermiques (17) forment sur la face externe de la paroi de boîtier (5) des surfaces de montage (25) qui se situent dans un même plan.

16. Boîtier selon la revendication 1, **caractérisé en ce que** les ponts thermiques (17) forment sur la face interne de la paroi de boîtier (5) des surfaces de montage (19) qui se situent dans un même plan.

17. Boîtier selon la revendication 1, **caractérisé en ce que** les surfaces de montage (19, 21) comportent des trous taraudés (22, 25).

18. Boîtier selon la revendication 17, **caractérisé en ce que** les trous taraudés (22, 25) sont des trous borgnes.
